# EUROPÄISCHE PATENTSCHRIFT

(11) **EP 1 000 530 B1**
(45) Veröffentlichungstag und Bekanntmachung des Hinweises auf die Patenterteilung: **28.11.2001**
(21) Anmeldenummer: 98938648.7
(22) Anmeldetag: 25.06.1998
(51) Int. Cl.: H05K 5/03, B26B 19/38

(54) **GEHÄUSE INSBESONDERE FÜR EIN ELEKTROGERÄT**
BOX, IN PARTICULAR FOR ELECTRICAL APPLIANCE
BOITIER, NOTAMMENT POUR APPAREIL ELECTRIQUE

(30) Priorität: 01.08.1997 DE 19733361
(43) Veröffentlichungstag der Anmeldung: 17.05.2000
(73) Patentinhaber: Braun GmbH, 61476 Kronberg (DE)
(72) Erfinder: FRITSCH, Thomas, D-65817 Eppstein (DE); HERZOG, Karl, D-60489 Frankfurt am Main (DE); KRESSNER, Gerhard, D-63674 Altenstadt (DE)
(86) Internationale Anmeldenummer: EP9803886
(87) Internationale Veröffentlichungsnummer: WO9907195

(56) Entgegenhaltungen:
- DE-U- 7 905 922
- US-A- 5 256 953

## Beschreibung

Die Erfindung betrifft ein Gehäuse insbesondere für ein Elektrogerät, mit einem Gehäuseteil, das einen nicht-kreisförmigen Querschnitt aufweist, und das von einem lösbaren Gehäuseboden verschlossen ist.

Es sind zylinderförmige Gehäuseteile bekannt, die mit einem Gewinde oder dergleichem durch einen kreisförmigen Gehäuseboden verschlossen sind. Zum Öffnen des Gehäuseteils wird der Gehäuseboden von einem Benutzer durch Drehen in einen geöffneten Zustand überführt und dann aus dem Gehäuseteil herausgenommen. Beispielsweise bei einem Elektrogerät kann der Benutzer dann verbrauchte Batterien auswechseln.

Bei unrunden Gehäuseteilen sind andere Vorrichtungen bekannt, mit denen der ebenfalls unrunde Gehäuseboden an dem Gehäuseteil lösbar befestigt ist. Beispielsweise kann der Gehäuseboden in das Gehäuseteil eingesteckt und dort arretiert sein. Insbesondere im Vergleich zu dem beschriebenen einfachen Hinein- und Herausdrehen des Gehäusebodens ist ein derartiges Einstecken und Arretieren für den Benutzer häufig mit Schwierigkeiten verbunden.

Davon ausgehend ist es die Aufgabe der Erfindung, ein Gehäuse mit einem unrunden Gehäuseteil zu schaffen, dessen Gehäuseboden von einem Benutzer leicht geöffnet und verschlossen werden kann.

Diese Aufgabe wird bei einem Gehäuse der eingangs genannten Art erfindungsgemäß dadurch gelöst, daß der Gehäuseboden einen Außenboden und einen in dem Außenboden drehbar gelagerten Innenboden aufweist.

Mit Hilfe des drehbaren Innenbodens kann der Gehäuseboden in einfacher Weise von dem Benutzer geöffnet und verschlossen werden. Ein kompliziertes Einstecken des Gehäusebodens in das Gehäuseteil ist nicht erforderlich. Durch die Erfindung kann also der Benutzer den unrunden Gehäuseboden in gleicher Weise handhaben, wie er dies von dem kreisförmigen Gehäuseboden gewohnt ist. Das Öffnen und Schließen des Gehäuseteils beispielsweise zum Auswechseln von Batterien wird somit für den Benutzer wesentlich vereinfacht und damit erleichtert.

Bei einer vorteilhaften Weiterbildung der Erfindung weist die Außenkontur des Außenbodens etwa die Innenkontur des nicht-kreisförmigen Querschnitts des Gehäuseteils auf. Der eine Außenfläche des Gehäuses bildende Außenboden hat die Aufgabe, die zu verschließende Öffnung in dem Gehäuseteil abzudecken. Der Außenboden hat nicht die Aufgabe, eine Arretierung mit dem Gehäuseteil herzustellen oder sich zu drehen. Dadurch kann der Außenboden besonders gut an das Gehäuseteil angepaßt werden.

Bei einer weiteren vorteilhaften Weiterbildung der Erfindung weist der Außenboden eine kreisförmige Öffnung auf, in die sich der Innenboden erstreckt, und es weist die Außenkontur des Innenbodens etwa die Innenkontur der kreisförmigen Öffnung des Außenbodens auf. Die Öffnung in dem Außenboden wird also von dem Innenboden ausgefüllt. Insgesamt wird somit die Außenfläche im Bereich des Gehäusebodens von dem Außenboden und dem durchtretenden Vorsprung des Innenbodens gebildet. In diesem durchtretenden Vorsprung ist der Innenboden beispielsweise mit einem Schlitz oder dergleichen versehen. Mit Hilfe dieses Schlitzes kann der Benutzer den Innenboden in einfacher Weise drehen und damit den gesamten Gehäuseboden von einem geschlossenen Zustand in einen geöffneten Zustand überführen.

Bei einer vorteilhaften Ausgestaltung der Erfindung sind der Innenboden, das Gehäuseteil und der Außenboden in dem geschlossenen Zustand insbesondere durch Formschluß miteinander verbunden. Dies stellt eine einfache, aber sichere Befestigung des Gehäusebodens in dem Gehäuseteil dar. Der genannte geschlossene Zustand kann dabei dadurch erreicht werden, daß der Benutzer den Innenboden dreht und damit den Formschluß herbeiführt. In dem geöffneten Zustand ist der Formschluß nicht vorhanden, so daß der Gehäuseboden aus dem Gehäuseteil herausgenommen werden kann.

Besonders zweckmäßig ist es, wenn der Innenboden mindestens einen Arm aufweist, dem ein Durchbruch oder dergleichen im Inneren des Gehäuseteils zugeordnet ist, in die der Arm in dem geschlossenen Zustand eingreift, und wenn des weiteren der Innenboden mindestens einen Arm aufweist, dem ein Rahmen oder dergleichen an dem Außenboden zugeordnet ist, in den der Arm in dem geschlossenen Zustand eingreift. Diese Maßnahmen sind konstruktiv in einfacher Weise zu realisieren, gewährleisten aber trotzdem einen sicheren Formschluß und damit eine dauerhafte Befestigung des Gehäusebodens in dem Gehäuseteil.

Bei einer vorteilhaften Weiterbildung der Erfindung sind der Innenboden, insbesondere mindestens einer der Arme des Innenbodens, sowie das Gehäuseteil mit Arretierungsmitteln versehen, insbesondere mit einer Nase und einer zugeordneten Nut. Damit wird auf einfache Weise eine Arretierung des Innenbodens in dem geschlossenen Zustand erreicht. Der Innenboden kann sich dadurch nicht von selbst in seinen geöffneten Zustand verdrehen, und der Gehäuseboden kann sich somit nicht ohne Zutun des Benutzers aus dem Gehäuseteil lösen.

Bei einer weiteren vorteilhaften Weiterbildung der Erfindung ist zwischen dem Gehäuseteil und dem äußeren Boden eine Dichtung und/oder zwischen dem äußeren Boden und dem inneren Boden eine Dichtung angeordnet. Die vorzugsweise aus einem Elastomer bestehenden Dichtungen verhindern ein Eindringen von Wasser und/oder Schmutz in das Innere des Gehäuses. Zweckmäßigerweise können die Dichtungen entweder zwischen die genannten Bauteile eingelegt oder an mindestens eines der genannten Bauteile in einem Zwei-Komponenten-Spritzverfahren angebracht sein.

Dabei erweist es sich als vorteilhaft, daß mindestens eine der Dichtungen im Zwei-Komponenten-Spritzverfahren mit dem Gehäuseteil und/oder dem Außenboden und/oder dem Innenboden verbunden ist.

Schließlich besteht von Vorteil die Möglichkeit, daß Durchbrüche des Gehäuse-. teils außen durch eine aus Elastomer bestehende Schicht abgedeckt sind, wobei die Schicht in einem Zwei-Komponenten-Spritzverfahren mit dem Gehäuseteil verbunden ist.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt eine schematische Draufsicht auf einen Gehäuseboden eines Ausführungsbeispiels eines erfindungsgemäßen Gehäuses,
- Figur 2: zeigt einen schematischen Längsschnitt durch das Gehäuse der Figur 1 entlang der Ebene II - II der Figur 4,
- Figur 3: zeigt einen schematischen Längsschnitt durch das Gehäuse der Figur 1 entlang der Ebene III - III der Figur 2,
- Figur 4: zeigt einen schematischen Querschnitt durch das Gehäuse der Figur 1 entlang der Ebene IV - IV der Figur 2,
- Figur 5: zeigt einen schematischen Schnitt durch das Gehäuse der Figur 1 entlang der Ebene V - V der Figur 4,
- Figur 6: zeigt einen schematischen Schnitt durch das Gehäuse der Figur 1 entlang der Ebene VI - VI der Figur 4, und
- Figur 7: zeigt einen schematischen Querschnitt durch das Gehäuse der Figur 1 entsprechend der Figur 4.

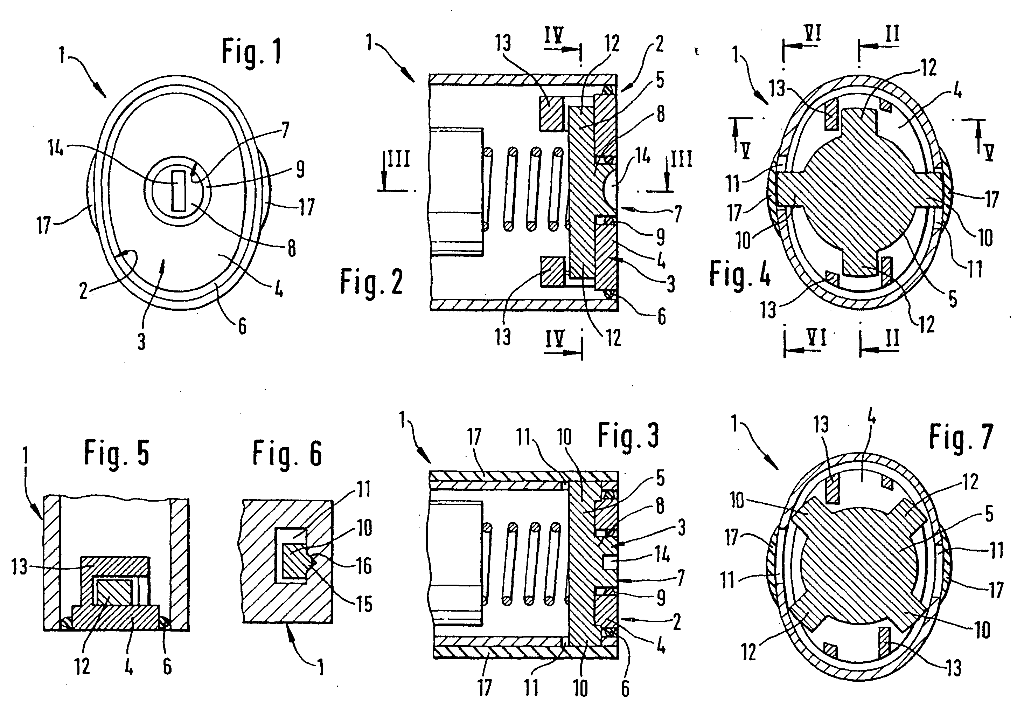

In den Figuren 1 bis 7 ist ein Gehäuseteil 1 eines Gehäuses dargestellt, das insbesondere als Gehäuse eines Elektrogeräts vorgesehen ist. Das Gehäuseteil 1 hat eine zylinderähnliche Form, weist jedoch einen nicht-kreisförmigen Querschnitt auf. Beispielsweise ist das Gehäuseteil 1 zur Unterbringung von einer oder mehrerer Batterien vorgesehen, die dann in Längsrichtung in dem Gehäuseteil 1 angeordnet sind.

Das Gehäuseteil 1 weist an seinem freien Ende eine Öffnung 2 mit einer etwa ovalen Innenkontur auf, die von einem Gehäuseboden 3 ausgefüllt ist. Es versteht sich, daß die Innenkontur der Öffnung 2 kein regelmäßiges Oval sein muß, sondern eine beliebige, auch asymmetrische, Form haben kann. Der Gehäuseboden 3 ist etwa quer zur Längsrichtung angeordnet und ist lösbar mit dem Gehäuseteil 1 verbunden. In einem geschlossenen Zustand deckt der Gehäuseboden 3 die Öffnung 2 in dem Gehäuseteil 1 ab und verschließt damit das Gehäuseteil 1. In einem geöffneten Zustand kann der Gehäuseboden 3 insbesondere mit Unterstützung einer Schraubendruckfeder oder dergleichen von dem Gehäuseteil 1 entfernt werden. Damit ist der Innenraum des Gehäuseteils 1 zugänglic,h und es können beispielsweise die darin untergebrachten Batterien herausgenommen werden.

Der Gehäuseboden 3 weist einen Außenboden 4 und einen Innenboden 5 auf. Der Außenboden 4 ist etwa bündig zu dem freien Ende des Gehäuseteils 1 angeordnet und bildet eine Außenfläche des Gehäuseteils 1 bzw. des Gehäuses. Der Innenboden 5 ist auf der dem Innenraum zugewandten Seite des Gehäuseteils 1 angeordnet.

Der Außenboden 4 weist eine etwa ovale Außenkontur auf, die der ovalen Innenkontur der Öffnung 2 im wesentlichen entspricht. Zwischen dem Außenboden 4 und dem Gehäuseteil 1 ist eine aus einem Elastomer bestehende Dichtung 6 angeordnet, die entweder zwischen den genannten Bauteilen eingelegt oder an einem der genannten Bauteile durch ein Zwei-Komponenten-Spritzverfahren angespritzt ist.

Etwa im Schnittpunkt der längsten und der kürzesten Ausdehnung der von dem Außenboden 4 gebildeten etwa ovalen Fläche weist der Außenboden 4 eine kreisförmige Öffnung 7 auf. In diese Öffnung 7 erstreckt sich der Innenboden 5 mit einem kreisförmigen Vorsprung 8. Die Außenkontur des Vorsprungs 8 entspricht im wesentlichen der Innenkontur der Öffnung 7. Zwischen dem Außenboden 4 und dem Vorsprung 8 des Innenbodens 5 ist eine aus einem Elastomer bestehende Dichtung 9 angeordnet, die entweder zwischen den genannten Bauteilen eingelegt oder an einem der genannten Bauteile durch ein Zwei-Komponenten-Spritzverfahren angespritzt ist.

Der Innenboden 5 ist mit seinem Vorsprung 8 in der Öffnung 7 und damit in dem Außenboden 4 drehbar gelagert. Die Drehachse ist etwa parallel zur Längsrichtung des Gehäuseteils 1 angeordnet. Der Außenboden 4 ist zusammen mit dem Innenboden 5 im Innenraum des Gehäuseteils 1 in Längsrichtung verschiebbar. Insbesondere kann der Außenboden 4 zusammen mit dem Innenboden 5 von dem Gehäuseteil 1 entfernt und herausgenommen werden. Ebenfalls ist der Innenboden 5 mit seinem Vorsprung 8 in der Öffnung 7 des Außenbodens 4 in Längsrichtung verschiebbar.

Der Innenboden 5 weist zwei Arme 10 auf, die etwa quer zur Längsrichtung des Gehäuseteils 1 und etwa einander entgegengesetzt angeordnet sind, und die sich in Richtung zu denjenigen Innenwänden des Gehäuseteils 1 erstrecken, die einen kürzeren Abstand zueinander aufweisen. In diesen Innenwänden sind zwei bis nach außen reichende Durchbrüche 11 enthalten, die den beiden Armen 10 zugeordnet sind. Die Arme 10 und die Durchbrüche 11 sind derart ausgebildet, daß in dem geschlossenen Zustand jeder der Arme 10 in den jeweils zugeordneten Durchbruch 11 eingreift und mit diesem einen Formschluß bildet. Auf diese Weise ist im geschlossenen Zustand der Innenboden 5 fest mit dem Gehäuseteil 1 verbunden.

Des weiteren weist der Innenboden zwei Arme 12 auf, die etwa quer zur Längsrichtung des Gehäuseteils 1 und etwa einander entgegengesetzt angeordnet sind, und die sich in Richtung zu denjenigen Innenwänden des Gehäuseteils 1 erstrecken, die einen größeren Abstand zueinander aufweisen. Von dem Außenboden 4 stehen in den Innenraum des Gehäuseteils 1 zwei im wesentlichen U-förmige Rahmen 13 ab, die den beiden Armen 12 zugeordnet sind. Die Arme 12 und die Rahmen 13 sind derart ausgebildet, daß in dem geschlossenen Zustand jeder der Arme 12 in den jeweils zugeordneten Rahmen 13 eingreift und mit diesem einen Formschluß bildet. Auf diese Weise ist im geschlossenen Zustand der Außenboden 4 fest mit dem Innenboden 5 und damit auch fest mit dem Gehäuseteil 1 verbunden.

Die vier Arme 10 und 12 sind abwechselnd in einem Winkel von etwa 90 Grad zueinander angeordnet. Die zugeordneten Durchbrüche 11 und Rahmen 13 sind derart ausgebildet, daß die Arme 10, 12 aus dem beschriebenen geschlossenen Zustand in den geöffneten Zustand übergehen können. In diesem geöffneten Zustand liegen die Arme 10 außerhalb der Durchbrüche 11 und die Arme 12 außerhalb der Rahmen 13. Der geschlossene Zustand ist insbesondere in der Figur 4 und der geöffnete Zustand in der Figur 7 dargestellt.

In den durch die Öffnung 7 hindurchstehenden Vorsprung 8 des Innenbodens 5 ist außen ein Schlitz 14 eingebracht. In diesen Schlitz 14 kann eine Münze oder dergleichen eingesteckt werden, mit der der Innenboden 5 von dem geöffneten Zustand in den geschlossenen Zustand und umgekehrt um einen Winkel von etwa 45 Grad gedreht werden kann. Es versteht sich, daß auch anders geformte Profile an die Stelle des Schlitzes 14 treten können.

Einer der Arme 10 des Innenbodens 5 ist mit einer Nase 15 versehen, der eine Nut 16 in dem zugehörigen Durchbruch 11 des Gehäuseteils 1 zugeordnet ist. Die Nase 15 rastet in dem geschlossenen Zustand in die Nut 16 ein. Auf diese Weise ist der Innenboden 5 in dem geschlossenen Zustand arretiert. Es versteht sich, daß auch beide Arme 10 mit derartigen Nasen 15 und zugeordneten Nuten 16 und/oder die Arme 12 und die Rahmen 13 mit derartigen Arretierungsmitteln versehen sein können.

Auf der Außenseite des Gehäuseteils 1 sind die Durchbrüche 11 mit einer aus einem Elastomer bestehenden Schicht 17 abgedeckt, die beispielsweise in einem Zwei-Komponenten-Spritzverfahren mit dem Gehäuseteil 1 verbunden ist. Die aus Elastomer bestehende Schicht 17 verbessert die Griffigkeit des Gehäuseteils 1. Es versteht sich, daß anstelle der Durchbrüche 11 auch außen geschlossene Ausnehmungen in der Innenwand des Gehäuseteils 1 vorgesehen sein können.

## Patentansprüche

1. Gehäuse insbesondere für ein Elektrogerät, mit einem Gehäuseteil (1), das einen nicht-kreisförmigen Querschnitt aufweist, und das von einem lösbaren Gehäuseboden (3) verschlossen ist, **dadurch gekennzeichnet, daß** der Gehäuseboden (3) einen Außenboden (4) und einen in dem Außenboden (4) drehbar gelagerten Innenboden (5) aufweist.

2. Gehäuse nach Anspruch 1, **dadurch gekennzeichnet, daß** die Außenkontur des Außenbodens (4) etwa die Innenkontur des nicht-kreisförmigen Querschnitts des Gehäuseteils (1) aufweist.

3. Gehäuse nach einem der Ansprüche 1 oder 2, **dadurch gekennzeichnet, daß** der Außenboden (4) eine kreisförmige Öffnung (7) aufweist, in die sich der Innenboden (5) erstreckt, und daß die Außenkontur des Innenbodens (5) etwa die Innenkontur der kreisförmigen Öffnung (7) des Außenbodens (4) aufweist.

4. Gehäuse nach einem der Ansprüche 1 bis 3, **dadurch gekennzeichnet, daß** der Innenboden (5), das Gehäuseteil (1) und der Außenboden (4) in einem geschlossenen Zustand insbesondere durch Formschluß miteinander verbunden sind.

5. Gehäuse nach Anspruch 4, **dadurch gekennzeichnet, daß** der Innenboden (5) mindestens einen Arm (10) aufweist, dem ein Durchbruch (11) im Inneren des Gehäuseteils (1) zugeordnet ist, in die der Arm (10) in dem geschlossenen Zustand eingreift.

6. Gehäuse nach einem der Ansprüche 4 oder 5, **dadurch gekennzeichnet, daß** der Innenboden (5) mindestens einen Arm (12) aufweist, dem ein Rahmen (13) an dem Außenboden (4) zugeordnet ist, in den der Arm (12) in dem geschlossenen Zustand eingreift.

7. Gehäuse nach einem der Ansprüche 1 bis 6, **dadurch gekennzeichnet, daß** der Innenboden (5), insbesondere mindestens einer der Arme (10) des Innenbodens (5), sowie das Gehäuseteil (1) mit Arretierungsmitteln versehen sind, insbesondere mit einer Nase (15) und einer zugeordneten Nut (16).

8. Gehäuse nach einem der Ansprüche 1 bis 7, **dadurch gekennzeichnet, daß** zwischen dem Gehäuseteil (1) und dem Außenboden (4) eine Dichtung (6) angeordnet ist, und/oder daß zwischen dem Außenboden (4) und dem Innenboden (5) eine Dichtung (9) angeordnet ist.

9. Gehäuse nach Anspruch 8, **dadurch gekennzeichnet, daß** mindestens eine der Dichtungen (6, 9) im Zwei-Komponenten-Spritzverfahren mit dem Gehäuseteil (1) und/oder dem Außenboden (4) und/oder dem Innenboden (5) verbunden ist.

10. Gehäuse nach einem der Ansprüche 1 bis 9, **dadurch gekennzeichnet, daß** Durchbrüche (11) des Gehäuseteils (1) außen durch eine aus Elastomer bestehende Schicht (17) abgedeckt sind, wobei die Schicht (17) in einem Zwei-Komponenten-Spritzverfahren mit dem Gehäuseteil (1) verbunden ist.

## Claims

1. A housing, in particular for an electric appliance, having a housing part (1) with a noncircular cross section closed by a detachable housing bottom (3), **characterized in that** the housing bottom (3) is comprised of an outer bottom (4) and an inner bottom (5) rotatably mounted in the outer bottom (4).

2. The housing as claimed in claim 1, **characterized in that** the outer contour of the outer bottom (4) has roughly the inner contour of the housing part's (1) noncircular cross section.

3. The housing as claimed in any one of the claims 1 or 2, **characterized in that** the outer bottom (4) has a circular opening (7) into which the inner bottom (5) extends, and the outer contour of the inner bottom (5) has roughly the inner contour of the circular opening (7) in the outer bottom (4).

4. The housing as claimed in any one of the claims 1 to 3, **characterized in that** in a closed state the inner bottom (5), the housing part (1) and the outer bottom (4) are joined together in particular by positive engagement.

5. The housing as claimed in claim 4, **characterized in that** the inner bottom (5) has at least one arm (10) which cooperates with a cutout (11) in the interior of the housing part (1) into which the arm (10) engages in the closed state.

6. The housing as claimed in any one of the claims 4 or 5, **characterized in that** the inner bottom (5) has at least one arm (12) which cooperates with a frame (13) on the outer bottom (4) into which the arm (12) engages in the closed state.

7. The housing as claimed in any one of the claims 1 to 6, **characterized in that** the inner bottom (5), in particular at least one of the arms (10) of the inner bottom (5), and the housing part (1) are equipped with locking elements, particularly with a nose (15) and a cooperating groove (16).

8. The housing as claimed in any one of the claims 1 to 7, **characterized in that** a seal (6) is positioned between the housing part (1) and the outer bottom (4), and/or a seal (9) is placed between the outer bottom (4) and the inner bottom (5).

9. The housing as claimed in claim 8, **characterized in that** at least one of the seals (6, 9) is joined to the housing part (1) and/or to the outer bottom (4) and/or to the inner bottom (5) in a two-component injection molding process.

10. The housing as claimed in any one of the claims 1 to 9, **characterized in that** cutouts (11) in the housing part (1) are covered from the outside by a layer (17) of elastomer, said layer (17) being joined to the housing part (1) in a two-component injection molding process.

## Revendications

1. Boîtier, en particulier pour un appareil électrique, comportant une partie de boîtier (1) qui présente une section non circulaire et qui est refermée par un fond de boîtier détachable (3), **caractérisé en ce que** le fond de boîtier (3) comporte un fond extérieur (4) et un fond intérieur (5) monté avec faculté de rotation dans le fond extérieur (4).

2. Boîtier selon la revendication 1, **caractérisé en ce que** le contour extérieur du fond extérieur (4) présente approximativement le contour intérieur de la section non circulaire de la partie de boîtier (1).

3. Boîtier selon l'une ou l'autre des revendications 1 et 2, **caractérisé en ce que** le contour extérieur (4) présente une ouverture circulaire (7) dans laquelle s'étend le fond intérieur (5), et **en ce que** le contour extérieur du fond intérieur (5) présente approximativement le contour intérieur de l'ouverture circulaire (7) du fond extérieur (4).

4. Boîtier selon l'une quelconque des revendications 1 à 3, **caractérisé en ce que** dans un état fermé, le fond intérieur (5), la partie de boîtier (1) et le fond extérieur (4) sont reliés les uns aux autres en particulier par coopération de formes.

5. Boîtier selon la revendication 4, **caractérisé en ce que** le fond intérieur (5) comporte au moins un bras (10) auquel est associée une traversée (11) dans l'intérieur de la partie de boîtier (1), dans laquelle s'engage le bras (10) dans l'état fermé.

6. Boîtier selon l'une ou l'autre des revendications 4 et 5, **caractérisé en ce que** le fond intérieur (5) comporte au moins un bras (12) auquel est associé un cadre (13) sur le fond extérieur (4), dans lequel s'engage le bras (12) dans l'état fermé.

7. Boîtier selon l'une quelconque des revendications 1 à 6, **caractérisé en ce que** le fond intérieur (5), en particulier l'un au moins des bras (10) du fond intérieur (5) ainsi que la partie de boîtier (1) sont pourvus de moyens d'arrêt, en particulier d'un bec (15) et d'une gorge associée (16).

8. Boîtier selon l'une quelconque des revendications 1 à 7, **caractérisé en ce qu'**un joint d'étanchéité (6) est agencé entre la partie de boîtier (1) et le fond extérieur (4), et/ou **en ce qu'**un joint d'étanchéité (9) est agencé entre le fond extérieur (4) et le fond intérieur (5).

9. Boîtier selon la revendication 8, **caractérisé en ce que** l'un au moins des deux joints d'étanchéité (6, 9) est relié à la partie de boîtier (1) et/ou au fond extérieur (4) et/ou au fond intérieur (5) par un procédé d'injection à deux composantes.

10. Boîtier selon l'une quelconque des revendications 1 à 9, **caractérisé en ce que** des traversées (11) de la partie de boîtier (1) sont recouvertes à l'extérieur par une couche (17) constituée en élastomère, la couche (17) étant reliée à la partie de boîtier (1) par un procédé d'injection à deux composantes.
